(19) Europäisches Patentamt / European Patent Office / Office européen des brevets

(11) **EP 4 365 611 B1**

(12) **EUROPEAN PATENT SPECIFICATION**

(45) Date of publication and mention
of the grant of the patent:
**26.11.2025 Bulletin 2025/48**

(21) Application number: **22933884.3**

(22) Date of filing: **14.12.2022**

(51) International Patent Classification (IPC):
*G01R 31/387* (2019.01)   *G01R 31/367* (2019.01)
*G01R 31/389* (2019.01)   *H01M 10/48* (2006.01)
*G01R 31/392* (2019.01)   *G06N 3/08* (2023.01)

(52) Cooperative Patent Classification (CPC):
**H01M 10/48; G01R 31/367; G01R 31/387;
G01R 31/392; G06N 3/08;** G01R 31/389;
Y02E 60/10

(86) International application number:
**PCT/JP2022/045986**

(87) International publication number:
**WO 2023/188582 (05.10.2023 Gazette 2023/40)**

(54) **SECONDARY BATTERY CAPACITY ESTIMATION SYSTEM**

SYSTEM ZUR SCHÄTZUNG DER KAPAZITÄT EINER SEKUNDÄRBATTERIE

SYSTÈME D'ESTIMATION DE CAPACITÉ DE BATTERIE SECONDAIRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **29.03.2022 JP 2022053027**

(43) Date of publication of application:
**08.05.2024 Bulletin 2024/19**

(73) Proprietor: **Toyo System Co., Ltd.
Iwaki-shi, Fukushima 972-8316 (JP)**

(72) Inventors:
• **MUNAKATA, Ichiro
Iwaki-shi, Fukushima 972-8316 (JP)**

• **IGARI, Shuntaro
Iwaki-shi, Fukushima 972-8316 (JP)**
• **TANNO, Satoshi
Iwaki-shi, Fukushima 972-8316 (JP)**
• **SHOJI, Hideki
Iwaki-shi, Fukushima 972-8316 (JP)**

(74) Representative: **Schön, Christoph
Dr. Schön, Neymeyr & Partner mbB
Bavariaring 26
80336 München (DE)**

(56) References cited:
WO-A1-2015/198631    WO-A1-2020/027203
JP-A- 2016 090 346    JP-A- 2016 090 346
JP-A- 2017 126 462    JP-A- 2020 085 653
JP-A- 2022 011 802    US-A1- 2017 294 689

**Description**

Technical Field

The present invention relates to a system for estimating the capacity of a secondary battery.

Background Art

As degradation degree evaluation indexes of a secondary battery, there are a capacity retention rate (a ratio of the current capacity to the initial capacity or the rated capacity) and an internal resistance increase rate (an increase ratio of the current internal resistance value to the initial internal resistance value), but it is common to use the capacity retention rate as SOH (State Of Health). In order to measure the capacity retention rate of the secondary battery accurately, it takes time because it is necessary to charge the secondary battery to 100 percent capacity and then discharge the secondary battery to 0 percent capacity again. Therefore, it is difficult to actually measure the capacity retention rate of a secondary battery while a device on which the secondary battery is mounted is in operation. On the other hand, it is possible to measure the internal resistance in a short time, for example, like in Patent Literature 1. Then, there is a correlation between the capacity retention rate and the internal resistance increase rate, and the capacity retention rate can be estimated to some extent from the internal resistance increase rate of the secondary battery using the correlation therebetween.

For example, according to a technique described in Patent Literature 2, the battery capacity of a secondary battery is estimated using a relational expression obtained by calculating the internal resistance of the secondary battery based on the current and voltage measurements obtained from the secondary battery and analyzing the correlation between the internal resistance and the battery capacity measurement result.

Citation List

Patent Literatures

Patent Literature 1: Domestic re-publication of PCT international application No. JP WO 2019-187264
Patent Literature 2: Japanese Patent Application Laid-Open No. 2018-072346

Summary of Invention

Technical Problem

Note that in the case of EVs, the usage histories of secondary batteries in the real world (such as environmental temperature, the number of charging times, fast-charging frequency, usage SOC range, etc.) vary from secondary battery to secondary battery. Then, for example, even when the internal resistance increase rate, that is, the increase ratio of the current internal resistance value to the initial internal resistance increase rate is the same, the capacity retention rates of secondary batteries may greatly differ from secondary battery to secondary battery depending on the usage history. Therefore, it is required to consider differences in secondary battery usage history in order to suppress an estimation error when estimating the capacity retention rate of a secondary battery from the internal resistance increase rate of the secondary battery.

However, in the technique described in Patent Literature 2, since the correlation between the internal resistance and the battery capacity measurement result is analyzed and the relational expression is obtained, the usage history of the secondary battery is not considered when deriving the relational expression. Therefore, a battery capacity estimation error based on the internal resistances of secondary batteries caused by different usage histories of the secondary batteries cannot be suppressed.

Further, the usage history that affects the capacity retention rate of each secondary battery contains various factors as described above, and there are countless combinations thereof. Therefore, it is not realistic to prepare a relational expression(s) corresponding to all of the countless combinations in advance.

Therefore, it is an object of the present invention to provide a secondary battery capacity estimation system that can efficiently estimate the capacity of a secondary battery from the internal resistance of the secondary battery even when the usage history is different from secondary battery to secondary battery.

Solution to Problem

A secondary battery capacity estimation system of the present invention is a system that estimates the capacity of a secondary battery, which includes:

a target secondary battery information acquisition unit that acquires target secondary battery information composed of information indicative of the usage history of a target secondary battery for which a capacity index value indicative of a degree of change in the capacity compared to the initial capacity of the secondary battery is to be estimated, and a resistance index value indicative of a degree of increase in internal resistance value compared to an initial internal resistance value of the target secondary battery;

a group determination unit that inputs, to a classification model, the information indicative of the usage history of the target secondary battery and the resistance index value included in the target secondary battery information to determine to which of a plurality of trend groups, each indicative of the classification of a declining trend in the capacity index value by use, the target secondary battery is relevant;

a learning unit that generates the classification model, and

a storage unit that stores correlation information indicative of a correlation between the resistance index value and the capacity index value of the secondary battery corresponding to each of the plurality of trend groups; and

a capacity estimation unit that acquires the correlation information corresponding to the trend group determined by the group determination unit to which the target secondary battery is relevant to estimate the capacity index value of the target secondary battery based on the resistance index value included in the target secondary battery information and the acquired correlation information, wherein

the classification model is a trained model obtained by machine learning using, as training data, sample secondary battery information composed of pieces of information indicative of respective usage histories of a plurality of sample secondary batteries and resistance index values and capacity index values of the plurality of sample secondary batteries, and configured to output the trend group to which the target secondary battery is relevant when the target secondary battery information of the target secondary battery is input,

the information indicative of the usage histories included in the sample secondary battery information is composed of pieces of information related to a plurality of items indicative of the usage histories of the sample secondary batteries,

the classification model is configured to classify the target secondary battery into any of the trend groups using weighting values for the items indicative of the usage histories of the sample secondary batteries, and

the learning unit is configured to

perform machine learning using the sample secondary battery information as training data in order to calculate the weighting value for each of the items, and

perform the machine learning again using, as training data, information in which some of the items whose weighting values are a predetermined value or less are excluded in order to generate the classification model.

According to the secondary battery capacity estimation system of the present invention, the usage history and the resistance index value indicative of the degree of increase in internal resistance value compared to the initial internal resistance value of the target secondary battery are input by the group determination unit to the classification model to determine to which of the plurality of trend groups, each indicative of the classification of the declining trend in the capacity index value by use (a value indicative of the degree of change in capacity compared to the initial capacity of the secondary battery), the target secondary battery is relevant.

Note that the classification model is a trained model obtained by machine learning using, as training data, the respective usage histories of the plurality of sample secondary batteries and resistance index values and capacity index values of the plurality of sample secondary batteries.

Further, the classification model is configured to output a trend group to which the target secondary battery concerned is relevant when the information indicative of the usage history of the target secondary battery and the resistance index value of the target secondary battery (that is, the target secondary battery information) is input.

Then, the correlation information corresponding to the trend group determined by the group determination unit to which the target secondary battery is relevant is acquired by the capacity estimation unit to estimate the capacity index value of the target secondary battery based on the resistance index value included in the target secondary battery information and the acquired correlation information.

Note that the correlation information is information indicative of a correlation between the resistance index value and the capacity index value of each secondary battery corresponding to each of the plurality of trend groups.

Thus, since the usage history of the secondary battery is considered in addition the resistance index value when estimating the capacity index value of the secondary battery, an estimation error of the capacity index value caused by the fact that the usage history of the secondary battery is different from secondary battery to secondary battery can be suppressed.

Further, since it is only necessary to prepare a number of pieces of correlation information according to the number of trend groups, the capacity index values can be estimated efficiently even when usage histories of secondary batteries vary and there are countless combinations thereof.

Thus, according to the present invention, even when the usage history of a secondary battery is different from others, the capacity of the secondary battery can be estimated efficiently from the state of the internal resistance of the secondary battery. Further, the classification model is configured to classify the target secondary battery into any of the trend groups using weighting values for the items indicative of the usage histories of the sample secondary batteries. Then, the classification model is generated by performing the machine learning again using training data in which some of the items whose weighting values are the predetermined value or less are excluded. Thus, since information to be input to the classification model to determine the trend group of the target secondary battery can be narrowed down to information related to items high in importance affecting the determination of the trend group to a certain extent among pieces of usage history information of secondary batteries, a trend group can be determined efficiently with little information. Thus, according to the present invention, the estimation error of the capacity index value caused by the fact that the usage history of the secondary battery is different from secondary battery to secondary battery can be suppressed efficiently.

Further, in the secondary battery capacity estimation system of the present invention, it is preferable that each piece of correlation information corresponding to each of the trend groups should be information obtained by classifying the pieces of sample secondary battery information into the trend groups to which the plurality of sample secondary batteries contained in the sample secondary battery information and analyzing a correlation between the resistance index value and the capacity index value related to each of the sample secondary batteries relevant to each of the trend groups.

There is a high probability that correlations between resistance index values and capacity index values of sample secondary batteries relevant to the same trend group will be approximate to one another. Then, correlation information obtained by grouping and analyzing the sample secondary batteries whose correlations are approximate to one another will be based on the actual situation.

According to the present invention, each piece of correlation information corresponding to each trend group is obtained by classifying the sample secondary batteries into trend groups and analyzing the correlation between the resistance index value and the capacity index value of each of the sample secondary batteries relevant to each trend group.

Therefore, according to the present invention, since the correlation information based on the actual situation is used to estimate the capacity index value of the target secondary battery, the estimation error of the capacity index value can be suppressed efficiently.

It is preferable that the secondary battery capacity estimation system of the present invention should include a learning unit that generates the correlation information, and the learning unit should be configured to

extract, from the sample secondary battery information, pieces of information related to the sample secondary batteries whose capacity index values are a predetermined value or less,
classify the extracted pieces of information into the plurality of trend groups depending on a degree of decline in the capacity index value, and
analyze a correlation between the resistance index value and the capacity index value related to each of the sample secondary batteries relevant to each of the trend groups depending on the degree of decline in the capacity index value in order to generate the correlation information corresponding to each of the trend groups.

With the user of a secondary battery, a decline in the capacity index value of the secondary battery is accelerated. Then, a secondary battery with the decline in the capacity index value accelerated to some extent compared to another secondary battery with the decline in the capacity index value not so accelerated is highly likely to clearly reflect a declining trend in the capacity index value by use.

According to the present invention, information related to sample secondary batteries whose capacity index values are reduced to a predetermined value or less is extracted by the learning unit from the sample secondary battery information, and pieces of the extracted information are classified into the plurality of trend groups depending on the degree of decline in the capacity index value.

Further, information related to each sample secondary battery relevant to each trend group is analyzed by the learning unit to generate correlation information corresponding to each trend group.

Thus, the correlation information can be generated based on the analysis results of the sample secondary battery information on the secondary batteries highly likely to clearly reflect the declining trend in the capacity index value by use and with the decline in the capacity index value accelerated to some extent.

Therefore, the estimation error of the capacity index value caused by the fact that the usage history of the secondary battery is different from secondary battery to secondary battery can be suppressed efficiently.

Brief Description of Drawings

FIG, 1 is a block diagram illustrating an example of the overall image of a secondary battery capacity estimation system of the present invention.

FIG. 2 is a diagram illustrating an example of the contents of data used for processing by the secondary battery capacity estimation system of the present invention.

FIG. 3 is an image chart illustrating an example of the contents of data used for processing by the secondary battery capacity estimation system of the present invention.

FIG. 4 is a flowchart illustrating an example of the processing content of the secondary battery capacity estimation system of the present invention.

FIG. 5 is a flowchart illustrating an example of the processing content of the secondary battery capacity estimation system of the present invention.

FIG. 6 is an image diagram illustrating an example of the processing content of the secondary battery capacity estimation system of the present invention.

FIG. 7 is a flowchart illustrating an example of the processing content of the secondary battery capacity estimation system of the present invention.

FIG. 8 is a chart illustrating an example of the output content of the secondary battery capacity estimation system of the present invention.

Description of Embodiment

<Configuration of Secondary Battery Capacity Estimation System>

A secondary battery capacity estimation system 10 of the present embodiment is a system that estimates the capacity of a secondary battery, which is, for example, a computer configured to include a control unit 110, a storage unit 130, an input unit 150, and an output unit 170. For example, the secondary battery capacity estimation system 10 may be implemented in a general-purpose computer such as a personal computer, a tablet, or a smartphone, or may be implemented in a terminal dedicated to carrying out the present invention. Besides, for example, when a target on which a secondary battery is mounted is a mobile object such as an automobile, the secondary battery capacity estimation system may be implemented as one function of a car navigation system or the like.

Note that the "capacity" of a secondary battery is the discharge capacity after the secondary battery is fully charged.

The control unit 110 is a so-called processor composed of an arithmetic processing unit such as a CPU (Central Processing Unit), memories, I/O (Input/Output) devices, and the like.

The control unit 110 reads and executes a predetermined program to function, for example, as a target secondary battery information acquisition unit 111, a group determination unit 113, a capacity estimation unit 115, and a learning unit 117.

The target secondary battery information acquisition unit 111 acquires target secondary battery information 501 composed of information indicative of the usage history of a target secondary battery 50 for which a capacity index value indicative of a degree of change in capacity compared to the initial capacity of the target secondary battery 50 is to be estimated, and a resistance index value indicative of a degree of increase in internal resistance compared to the initial resistance value of the target secondary battery 50.

Note that the initial capacity is, for example, the capacity at the time of manufacturing the secondary battery or when the secondary battery is mounted on a mounting target, or the rated capacity of the secondary battery. Then, the capacity index value is acquired, for example, by dividing the used capacity of the target secondary battery 50 by the initial capacity of the target secondary battery 50 according to Equation 1 below, which is a so-called SOH.

$$\text{Capacity index value} = C_x/C_o \times 100\ [\%]\ \dots\ (1)$$

Here, $C_x$ = Capacity of target secondary battery after being used, and $C_o$ = Initial capacity of target secondary battery.

Alternatively, the capacity index value may be acquired by dividing the amount of decrease in capacity from the initial capacity of the target secondary battery 50 by the initial capacity of the target secondary battery 50 according to Equation 2 below. The definitions of the variables are the same as above.

$$\text{Capacity index value} = (Cx-Co)/Co \times 100 \ [\%] \ ... \ (2)$$

Besides, the capacity index value may be a value obtained by expressing the capacity of the target secondary battery 50 in unit of Ah, or by expressing a difference from the initial capacity in unit of Ah.

Further, the initial internal resistance value is an internal resistance value at the time of manufacturing the secondary battery or when the secondary battery is mounted on a mounting target. Then, the resistance index value is acquired, for example, by dividing an increment of the internal resistance value from the initial internal resistance value of the target secondary battery 50 by the initial internal resistance value of the target secondary battery 50 according to Equation 3 below.

$$\text{Resistance index value} = (Rx-Ro)/Ro \times 100 \ [\%] \ ... \ (3)$$

Here, Rx = Internal resistance value of the target secondary battery after being used, and Ro = Initial internal resistance value of target secondary battery.

Alternatively, the resistance index value may be acquired, for example, by dividing the internal resistance value of the target secondary battery 50 by the initial internal resistance value of the target secondary battery 50 according to Equation 4 below. The definitions of variables are the same as those mentioned above.

$$\text{Resistance index value} = Rx/Ro \times 100 \ [\%] \ ... \ (4)$$

Besides, the resistance index value may be a value obtained by expressing the internal resistance value of the target secondary battery 50, for example, in unit of $\Omega$, or by expressing a difference from the initial internal resistance value in unit of $\Omega$.

The group determination unit 113 inputs, to a classification model 131, the information indicative of the usage history of the target secondary battery 50 and the resistance index value included in the target secondary battery information 501 to determine to which of the plurality of trend groups, each indicative of the classification of a declining trend of the capacity index value by use, the target secondary battery 50 is relevant.

The capacity estimation unit 115 acquires correlation information 133 corresponding to a trend group, determined by the group determination unit 113 that the target secondary battery 50 is relevant to, and estimates a capacity index value of the target secondary battery 50 based on the resistance index value included in the target secondary battery information 501 and the acquired correlation information 133.

The learning unit 117 generates the classification model 131 as a trained model obtained by machine learning using, as training data, information indicative of respective usage histories of the plurality of sample secondary batteries 70 (70a, 70b, 70c, ...) to be learned, and sample secondary battery information 701 composed of resistance index values and capacity index values of the plurality of sample secondary batteries 70.

The storage unit 130 is composed of storage devices such as a ROM (Read Only Memory), a RAM (Random Access Memory), an HDD (Hard Disk Drive), and the like. The storage unit 130 stores, for example, the processing results of the secondary battery capacity estimation system 10 and information used in processing by the secondary battery capacity estimation system 10 in addition to the classification model 131 and the correlation information 133.

The classification model 131 is a model to output a trend group to which the target secondary battery 50 is relevant when the target secondary battery information of the target secondary battery 50 is input.

The correlation information 133 is information indicative of a correlation between the capacity index value and the resistance index value of each secondary battery corresponding to each of the plurality of trend groups.

Each piece of correlation information 133 corresponding to each trend group is, for example, a relational expression expressing a correlation between the resistance index value and the capacity index value derived by performing regression analysis on each sample secondary battery 70 relevant to each trend group using the resistance index value as an independent variable and the capacity index value as a dependent variable after each of the sample secondary batteries 70 is classified into a trend group to which the sample secondary battery 70 is relevant, and analyzing the correlation.

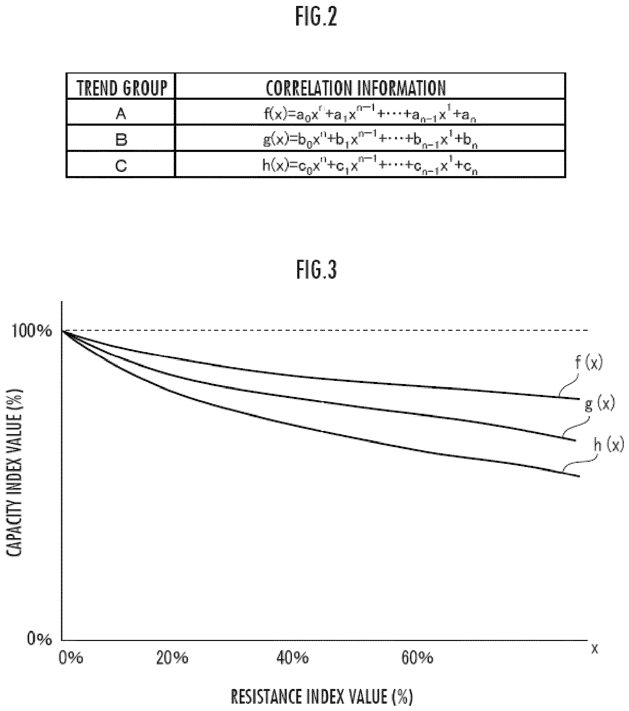

Respective pieces of the correlation information 133 are n-degree polynomials (f(x), g(x), h(x), ...) for respective trend groups (A, B, C, ...), for example, as illustrated in FIG. 2. When a relational expression corresponding to each trend group is illustrated in a graph, it is as in FIG. 3, for example. Note that an example in which curves indicating respective relational expressions do not intersect except when the capacity index value is 100% is illustrated in FIG. 3, but the curves indicating respective relational expressions may intersect depending on the learning processing result to be described later.

The input unit 150 accepts input of information necessary for processing of the secondary battery capacity estimation system 10 in addition to the target secondary battery information 501 and the sample secondary battery information 701.

The input unit 150 may be configured to include, for example, a connection terminal, a keyboard or a touch panel, a mouse, and any other pointing device to accept user input.

The output unit 170 is, for example, a display device for displaying, to an operator, information such as processing result information necessary to operate the secondary battery capacity estimation system 10, but it may also be a printing device such as a printer.

The target secondary battery 50 and the sample secondary batteries 70 are various kinds of batteries that can be mounted on and used in a mobile body driven using electricity as a power source such as a hybrid electric vehicle (HEV), a plug-in hybrid electric vehicle (PHEV), or a battery electric vehicle (BEV), a commercial power storage device, a household power storage device, electric transportation equipment (cart, forklift, or the like), a personal computer, or a mobile phone, which are batteries such as lead-acid batteries, NiCad batteries, nickel-metal hydride batteries, and lithium secondary batteries.

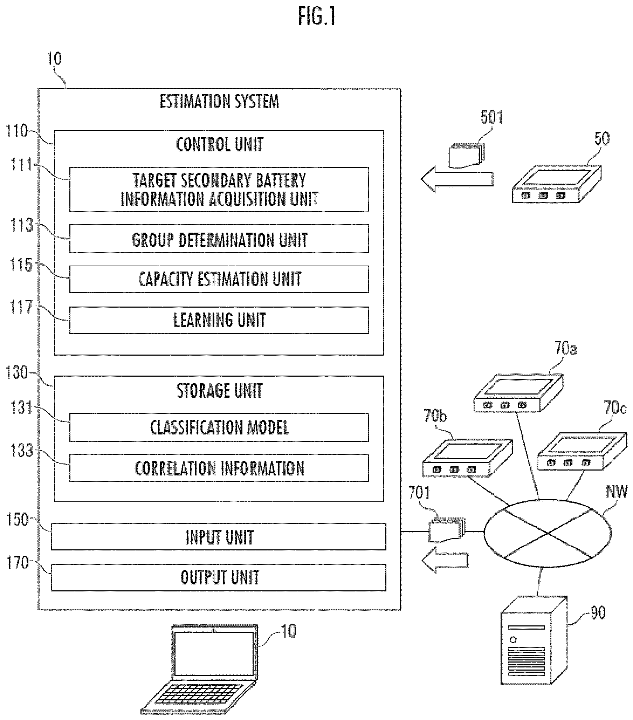

Note that the target secondary battery 50 and sample secondary batteries 70 in the demounted state are illustrated in FIG. 1, but the target secondary battery information 501 and the sample secondary battery information 701 may also be acquired in such a state that the target secondary battery 50 and the sample secondary batteries 70 are mounted on mounting targets.

"Information indicative of each usage history" included in the sample secondary battery information 701 is, for example, at least one or a combination of pieces of information recorded in chronological order and indicative of SOC when each sample secondary battery 70 starts discharging or charging, whether or not the charging is fast charging, the frequency thereof, and the environmental temperature of the sample secondary battery 70.

In general, each battery is designed to be used in an SOC range of 30 to 70% in the case of the HEV, and in an SOC range of 20 to 80% in the case of the PHEV. Thus, there is an operating SOC range appropriate for each secondary battery, and when the secondary battery is operated outside the appropriate SOC range, the stress such as the expansion of positive and negative electrode materials increases, and a decline in capacity index value is accelerated.

On the other hand, when the secondary battery is operated in a narrow SOC range, the stress on the secondary battery can be reduced and hence the acceleration of the decline in capacity index value can be slowed down moderately. Thus, information about in what SOC range the secondary battery has been used, which has a great impact on the acceleration of the decline in the capacity index value of the secondary battery, is important information for estimating the capacity index value of the secondary battery.

Further, when charging of the secondary battery is performed by fast-charging, the stress on the secondary battery is higher than when charging is performed by normal charging. Therefore, the information indicative of whether or not charging performed on the secondary battery is fast-charging and the frequency thereof is important information for estimating the capacity index value of the secondary battery.

Further, the fact that the secondary battery continues to be operated in a cold region or continues to be operated in high temperature conditions increases the stress on the secondary battery, which becomes a factor that causes the deterioration of the secondary battery to be accelerated. Therefore, information indicative of the environmental temperature at which the secondary battery was operated is also important information for estimating the capacity index value of the secondary battery.

As the "information indicative of the usage history" in the sample secondary battery information 701, important information for estimating the capacity index value of the secondary battery may also be included as appropriate in addition to the information exemplified above.

Further, the resistance index value and the capacity index value included in the sample secondary battery information 701 are acquired by a method similar to the method of acquiring the resistance index value and the capacity index value of target secondary battery 50 described above.

The sample secondary battery information 701 is recorded, for example, in a storage mechanism included in a mounting target of the sample secondary battery 70, or in a storage mechanism included in the sample secondary battery 70 itself. Then, for example, when inspecting equipment on which the sample secondary battery 70 is mounted, the sample secondary battery information 701 is collected by an inspector and stored on an external server 90 or the like. Alternatively, the sample secondary battery information 701 may be stored on the external server 90 or the like at any timing via a wired or wireless communication network NW.

Further, in the sample secondary battery information 701, resistance index values and capacity index values of the same sample secondary battery 70 at multiple different points in time can be included. In this case, information for identifying the sample secondary battery 70 may be further included in the sample secondary battery information 701.

<Processing Overview>

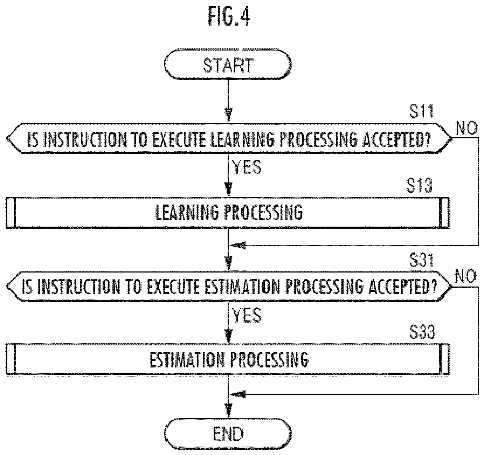

Next, the processing details of the secondary battery capacity estimation system 10 of the present embodiment will be described. Referring first to FIG. 4, a series of processing by the secondary battery capacity estimation system 10 will be described. As illustrated in FIG. 4, for example, when accepting an instruction to execute learning processing by the operator (FIG. 4/S11: Yes), the secondary battery capacity estimation system 10 of the present embodiment executes learning processing (FIG. 4/S13) to generate a classification model to output a trend group to which the target secondary battery is relevant when the information of the target secondary battery is input, and to acquire correlation information corresponding to the trend group.

Further, for example, when accepting an instruction to execute estimation processing by the operator (FIG. 4/S31: Yes), the secondary battery capacity estimation system 10 of the present embodiment executes estimation processing (FIG. 4/S33) for estimating the capacity index value of the target secondary battery.

Note that the learning processing (FIG. 4/S13) is executed at least once prior to the execution of the estimation processing (FIG. 4/S33). Alternatively, for example, the learning processing (FIG. 4/S13) may be repeatedly executed regularly or irregularly depending on the operator's operation.

<Learning Processing>

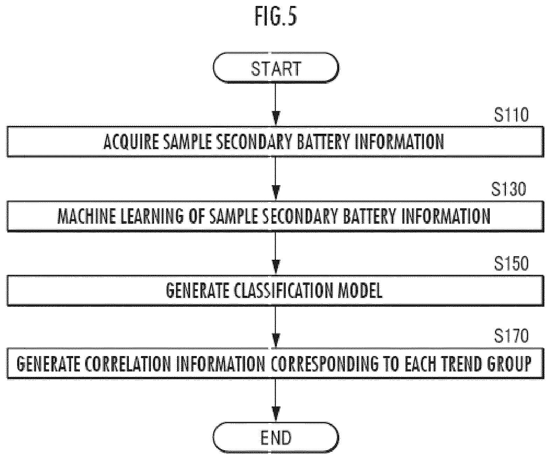

Referring next to FIG. 5, the learning processing will be described. When starting the processing, the learning unit 117 acquires the information indicative of the usage history of each of the plurality of sample secondary batteries to be learned, and the sample secondary battery information 701 composed of resistance index values and capacity index values of the plurality of sample secondary batteries (FIG. 5/S110).

For example, when a certain number of sample secondary battery information 701 is accumulated on the external server 90, the learning unit 117 acquires the sample secondary battery information 701 via an external storage medium or the wired or wireless communication network NW depending on the operator's operation.

After that, the learning unit 117 performs machine learning on the acquired sample secondary battery information 701 (FIG. 5/S130). In other words, for example, the learning unit 117 performs machine learning using, as training data, the information indicative of the usage history of each of the plurality of sample secondary batteries to be learned, and resistance index values and capacity index values of the plurality of sample secondary batteries 70 included in the sample secondary battery information 701.

For example, the learning unit 117 acquires information about an average usage SOC range of each of the sample secondary batteries 70 from the information indicative of the SOC when the sample secondary battery 70 concerned starts discharging or charging to use the information in the above machine learning as information indicative of the usage history.

In other words, for example, the learning unit 117 calculates the average SOC value (for example, 80%) when the sample secondary battery 70 starts discharging by summing up SOC values when the sample secondary battery 70 starts discharging and dividing the summed-up SOC value by the number of times the sample secondary battery 70 has been discharged.

Similarly, the learning unit 117 calculates the average SOC value (for example, 20%) when the sample secondary battery 70 starts charging by summing up SOC values when the sample secondary battery 70 starts charging and dividing the summed-up SOC value by the number of times the sample secondary battery 70 has been charged.

Thus, the acquired average value range (for example, 80% to 20%) is acquired as the average usage SOC range of the sample secondary battery 70.

Further, for example, the learning unit 117 acquires information about the number of times fast-charging has been performed on the secondary battery from information indicative of whether or not the charging performed on the secondary battery is fast-charging, calculates information about a fast-charging frequency by dividing the acquired information by the number of charges performed on the secondary battery, and uses the calculated information in the above machine learning as the information indicative of the usage history.

Alternatively, for example, the learning unit 117 calculates the average value from the information indicative of the environmental temperature when the sample secondary battery 70 was operating to acquire information on the average usage environmental temperature of the sample secondary battery 70, and uses the information in the above machine learning as the information indicative of the usage history.

Note, for example, that when the information on the average usage SOC range, the fast-charging frequency, or the average usage environmental temperature is included in advance in the sample secondary battery information 701, the processes of calculating these pieces of information performed by the learning unit 117 as mentioned above are omitted.

Then, based on the results of the machine learning, the learning unit 117 generates the classification model 131 (FIG. 5/S150) or updates the classification model 131 to output a trend group to which the target secondary battery 50 is relevant when the target secondary battery information 501 of the target secondary battery 50 is input, and stores the classification model 131 in the storage unit 130.

More specifically, for example, the learning unit 117 clusters the acquired sample secondary battery information 701 into any number (three in the present embodiment) of trend groups. Thus, pieces of sample secondary battery information 701 similar in declining trend of the capacity index value to one another are grouped.

As the methods for clustering the sample secondary battery information 701, known algorithms as well as K-means, Fuzzy c-means, Gaussian mixture model, and the like may be used as appropriate.

The processing mentioned above can obtain information on a trend group to which each record of the sample secondary battery information 701 included in the sample secondary battery information 701 is relevant. Then, the learning unit 117 uses, as training data, the information of the trend group thus obtained, to which each record of the sample secondary battery information 701 is relevant, and the information indicative of the usage history and the resistance index value included in the sample secondary battery information 701 to perform machine learning on a correspondence between the information indicative of the usage history and the resistance index value, and the trend group in order to generate the classification model 131.

As the classification model 131 generated by the learning unit 117, for example, a convolutional neural network (CNN)) is used, but any other model such as a linear regression model, a polynomial regression model, or a multiple regression model may also be used as appropriate.

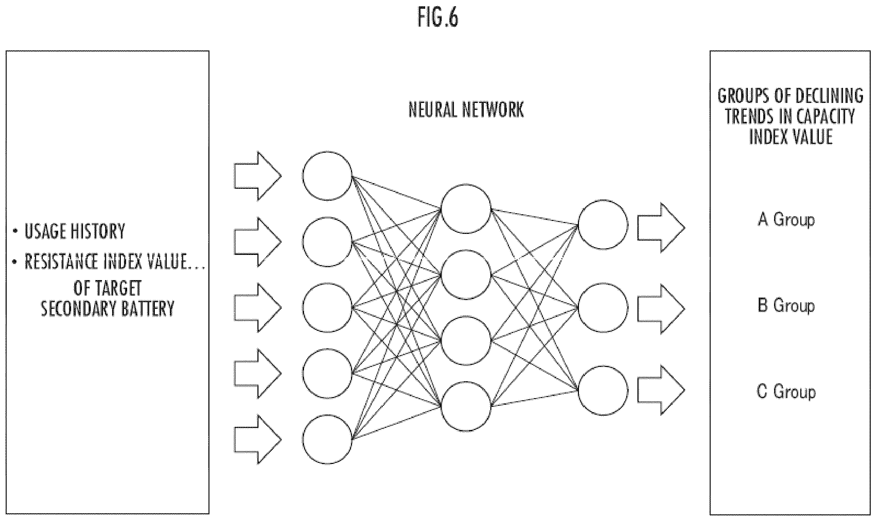

FIG. 6 is a diagram illustrating an example of the classification model 131 thus generated. As illustrated in FIG. 6, the classification model 131 is, for example, a neural network using, as input, the information indicative of the usage history of the target secondary battery 50, the information of the resistance index value of the target secondary battery 50, and the like to output a trend group to which the target secondary battery 50 is relevant among the plurality of trend groups indicative of the classification of declining trends in capacity index value. The classification model 131 is configured, for example, to output a probability value corresponding to each trend group, respectively. Note that the number of trend groups is three in FIG. 6, that is, A, B, and C as described above, but the number of trend groups may be any number of 2 or more.

Subsequently, the learning unit 117 generates correlation information 133 corresponding to each trend group (FIG. 5/S170) and stores the correlation information 133 in the storage unit 130.

More specifically, for example, the learning unit 117 extracts a record corresponding to each trend group from the sample secondary battery information 701, and analyzes a correlation between the resistance index value and the capacity index value of the extracted record to generate the correlation information 133 corresponding to each trend group. In other words, in the present embodiment, the learning unit 117 generates three pieces of correlation information 133 corresponding to respective trend groups of A, B, and C.

Thus, the learning unit 117 ends the series of processes in the learning processing.

<Estimation Processing>

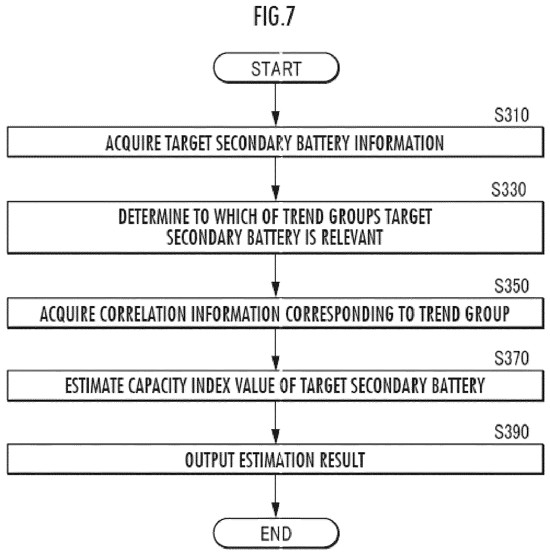

When this processing is started, the target secondary battery information acquisition unit 111 first acquires the target secondary battery information 501 composed of information indicative of the usage history of the target secondary battery 50 the capacity index value of which is to be estimated, and the resistance index value indicative of a degree of increase in internal resistance compared to the initial internal resistance value of the target secondary battery (FIG. 7/310).

For example, the target secondary battery information 501 is recorded in a storage mechanism included in the mounting target of the target secondary battery 50, or a storage mechanism included in the target secondary battery 50 itself. Then, for example, the target secondary battery information acquisition unit 111 acquires the target secondary battery information 501 according to an inspector's operation when inspecting equipment on which the target secondary battery 50 is mounted, and the like. Alternatively, the target secondary battery information acquisition unit 111 may also be configured to acquire the target secondary battery information 501 at any timing via the wired or wireless communication network NW.

For example, the "information indicative of the usage history" included in the target secondary battery information 501 is at least one or a combination of pieces of information recorded in chronological order and indicative of SOC when the target secondary battery 50 starts discharging or charging, whether or not charging is fast-charging, and the environmental temperature of the target secondary battery 50, which are the same kinds of information as the "information indicative of the usage history" included in the sample secondary battery information 701 used by the learning unit 117 in the learning processing (FIG. 4/S13).

Therefore, when information important for estimating the capacity index value of the secondary battery is included in addition to the information exemplified above as the "information indicative of the usage history" of the sample secondary battery information 701, the information concerned may also be included in the target secondary battery information 501.

Note that when the information of the average usage SOC range of the sample secondary battery 70, the information of the fast-charging frequency, and the information of the average usage environmental temperature are used as the information indicative of the usage history in the machine learning by the learning unit 117, the target secondary battery information acquisition unit 111 acquires these pieces of information related to the target secondary battery 50 from the target secondary battery information 501 by a similar method to the method in which the learning unit 117 acquires these pieces of information from the sample secondary battery information 701. These acquired pieces of information are used in subsequent processing as the information indicative of the usage history of the target secondary battery 50.

After that, the group determination unit 113 inputs, to the classification model 131 stored in the storage unit 130, the information indicative of the usage history of the target secondary battery 50 and the resistance index value included in the target secondary battery information 501 to determine to which of the plurality of trend groups, indicative of the classification of declining trends in capacity index value by use, the target secondary battery 50 concerned is relevant (FIG. 7/S330).

More specifically, for example, the group determination unit 113 refers to the output results of the classification model 131 to determine a trend group to which the target secondary battery 50 is most likely to be relevant to be the trend group to which the target secondary battery 50 concerned is relevant. In the following, description will be made when the trend group to which the target secondary battery 50 is relevant is C group.

After that, the capacity estimation unit 115 acquires the correlation information 133 corresponding to the trend group determined as mentioned above (FIG. 7/S350). In other words, the capacity estimation unit 115 acquires the correlation information 133 corresponding to C group from the storage unit 130.

Then, the capacity estimation unit 115 estimates the capacity index value of the target secondary battery 50 based on the resistance index value included in the target secondary battery information 501 and the acquired correlation information 133 (FIG. 7/S370).

In other words, for example, the capacity estimation unit 115 estimates that the calculation result obtained by inputting internal resistance value increase information included in the target secondary battery information 501 as the value of x in the polynomial h(x) as illustrated in FIG. 2 is the capacity index value of the target secondary battery 50.

After that, for example, the capacity estimation unit 115 outputs the estimation result to the output unit 170 (FIG. 7/S390), and ends the series of estimation processing.

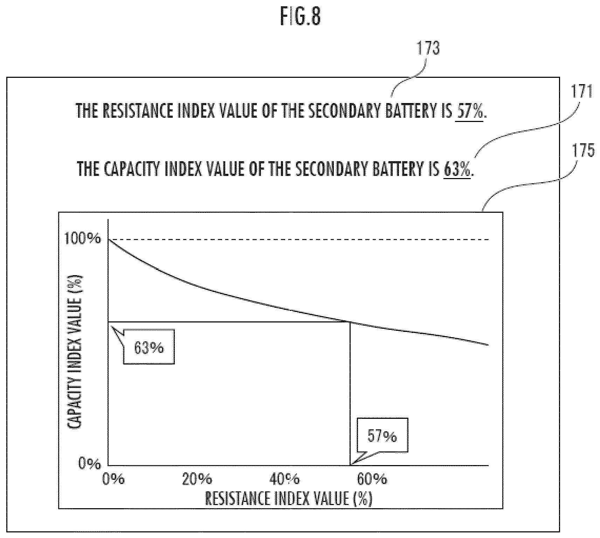

FIG. 8 illustrates an example of the output content of the estimation results of the present embodiment. In the output content, for example, it is output that the estimation result of the capacity index value of the secondary battery is 63% as display 171 indicative of the capacity index value of the target secondary battery 50. In other words, this display indicates the ratio of the current capacity to the initial capacity of the target secondary battery 50.

Alternatively, for example, in addition to this display, display 173 indicative of the resistance index value of the target secondary battery 50 and graph 175 indicative of a correlation between the resistance index value and the capacity index value may also be included in the output content. Besides, information indicative of the average usage SOC range, the fast-charging frequency, the average usage environmental temperature, and the like used to estimate the capacity index value may further be included.

The secondary battery capacity estimation system of the present embodiment has been described above, but the embodiment of the present invention is not limited thereto. In the following, other embodiments will be described.

<Modified Embodiments>

In the above, the case where the learning unit 117 groups pieces of sample secondary battery information 701 by clustering in the learning processing has been described, but the present invention is not limited to this case.

In other words, for example, the learning unit 117 may also be configured to group the pieces of sample secondary battery information 701 and perform the subsequent processes in the learning processing (FIG. 4/S13) in the following flow.

First, the learning unit 117 extracts, from the sample secondary battery information 701, pieces of information related to the sample secondary batteries whose capacity index values are reduced to a predetermined value or less. The fact that the "capacity index value is reduced to a predetermined value or less" is, for example, a state where the capacity index value is reduced to 60% or less, 50% or less, or the like, but any other appropriate value may be adopted as the predetermined value. Alternatively, for example, the learning unit 117 may be configured to extract pieces of information related to sample secondary batteries having capacity index values less than or equal to the average value of the capacity index values of the sample secondary batteries 70 included in the sample secondary battery information 701.

Subsequently, the learning unit 117 classifies the pieces of information related to the sample secondary batteries 70 extracted as mentioned above into the plurality of trend groups depending on the degree of decline in the capacity index value, and labels the information indicative of the trend groups to respective records.

The number of trend groups classified by the learning unit 117 is three, for example, A: the decline in the capacity index value is gradual, B: the decline in the capacity index value is moderate, and C: the decline in the capacity index value is fast, but the learning unit 117 may also be configured to classify the extracted pieces of information related to the sample secondary batteries 70 into trend groups the number of which is 2 or more.

In this case, the learning unit 117 performs machine learning using, as training data, pieces of sample secondary battery information 701 of respective sample secondary batteries 70 classified as mentioned above and information indicative of trend groups to which the respective sample secondary batteries 70 are relevant to generate or update the classification model 131 based on the results of the machine learning, and store the classification model 131 in the storage unit 130.

After that, the learning unit 117 analyzes a correlation between the resistance index value and the capacity index value related to each sample secondary battery 70 relevant to each trend group depending on the degree of decline in the capacity index value to generate the correlation information 133 corresponding to each trend group.

More specifically, for example, the learning unit 117 first extracts, from the sample secondary battery information 701, a resistance index value and a capacity index value related to each sample secondary battery 70 the capacity index value of which is reduced to the predetermined value or less and which is relevant to trend group A. At this time, the learning unit 117 may extract, from the sample secondary battery information 701, all records corresponding to the extraction conditions, or may extract some records corresponding to the extraction conditions by a given algorithm or the like, or depending on an operator's operation.

Then, the learning unit 117 analyzes a correlation between the resistance index value and the capacity index value related to each sample secondary battery 70 using the records thus extracted to generate the correlation information 133 corresponding to trend group A.

The learning unit 117 repeatedly executes these processes until the last trend group to generate the correlation information 133 corresponding to each trend group.

When the learning unit 117 is thus configured, for example, information indicating which is the trend group of the secondary battery concerned and the details (for example, "A: the decline in the capacity index value is gradual," and the like) may be further included in the output content by the secondary battery capacity estimation system 10.

Since the replacement of the secondary battery by new one is expensive, a user of the secondary battery desires for using a currently used secondary battery for a longer time without accelerating the decline in capacity index value as far as possible. Therefore, as mentioned above, if it is possible to inform the user whether the secondary battery is used in a way to accelerate the decline in capacity index value or used in a way to reduce the impact on the capacity index value, it can respond to user's needs to use the currently used secondary battery for a longer time without accelerating the decline in capacity index value as far as possible.

Alternatively, for example, the learning unit 117 may be configured to generate the classification model 131 in the learning processing (FIG. 4/S13) in the following flow.

In other words, for example, the learning unit 117 performs machine learning on training data containing items such as the average usage SOC range, the fast-charging frequency, and the average usage environmental temperature of each sample secondary battery 70 to calculate a weighting value for each of these items.

Then, the learning unit 117 generates the classification model 131 by performing the machine learning again using, as training data, information obtained by excluding items whose weighting values thus calculated are a predetermined value or less.

As the predetermined value for the weighting value to determine the necessity of excluding each item, any value may be set appropriately. Alternatively, for example, the learning unit 117 may be configured to exclude, from training data when the machine learning is performed again, items having weighting values less than or equal to predetermined % of the average value of weighting values for all items.

The modified embodiments of the secondary battery capacity estimation system 10 of the present invention have been described above, but the present invention is not limited thereto. Namely, for example, the embodiment in which the learning unit 117 is implemented in the secondary battery capacity estimation system 10 has been described, but the learning unit 117 may also be implemented in a computer different from the secondary battery capacity estimation system 10. In this case, the learning processing (FIG. 4/S13) is executed on the different computer to generate the classification model 131. Then, the generated classification model 131 is stored in the storage unit 130 of the secondary battery capacity estimation system 10 via a communication medium, a storage medium, or the like.

Alternatively, for example, the example in which the sample secondary battery information 701 containing the resistance index value of each sample secondary battery 70 is stored in the storage mechanism included in the mounting target of the sample secondary batteries 70 or the storage mechanism included in the sample secondary battery 70 itself is described above, but the present invention is not limited to this example.

In other words, for example, it may also be configured such that the internal resistance value of the sample secondary battery 70 is recorded in the storage mechanism included in the mounting target of the sample secondary battery 70 or the storage mechanism included in the sample secondary battery 70 itself, the initial internal resistance value of a secondary battery having the same model number as the sample secondary battery 70 concerned is recorded on the external server 90, and the resistance index value of the sample secondary battery 70 is acquired by the external server 90 dividing an increment of the internal resistance value of the sample secondary battery 70 by the initial internal resistance value of the secondary battery having the same model number as the sample secondary battery 70 concerned. In this case, information indicative of the model number of the sample secondary battery 70 is included in the sample secondary battery information 701.

Similarly, the example in which the target secondary battery information 501 containing the resistance index value of the target secondary battery 50 is stored in the storage mechanism included in the mounting target of the target secondary battery 50 or the storage mechanism included in the target secondary battery 50 itself is described above, but the present invention is not limited to this example.

In other words, for example, it may also be configured such that the internal resistance value of the target secondary battery 50 is recorded in the storage mechanism included in the mounting target of the target secondary battery 50 or the storage mechanism included in the target secondary battery 50 itself, the initial internal resistance value of a secondary battery having the same model number as the target secondary battery 50 concerned is recorded in the storage unit 130 of the secondary battery capacity estimation system 10, and the target secondary battery information acquisition unit 111 acquires the resistance index value of the target secondary battery 50 concerned by dividing an increment of the internal resistance value of the target secondary battery 50 by the initial internal resistance value of the secondary battery having the same model number as the target secondary battery 50 concerned. In this case, information indicative of the model number of the target secondary battery 50 is included in the target secondary battery information 501.

Alternatively, for example, when recognizing that there are two or more trend groups having the highest probability at which the target secondary battery 50 is relevant to the trend groups, the group determination unit 113 may determine these two or more trend groups to be the trend groups to which the target secondary battery 50 is relevant. In this case, for example, the capacity estimation unit 115 acquires pieces of correlation information 133 corresponding to the two or more trend groups determined as mentioned above to estimate a capacity index value when the target secondary battery 50 is relevant to each of these groups. Then, the capacity estimation unit 115 sets an average value of these estimated values as an estimated value for the capacity index value of the target secondary battery 50 concerned. Alternatively, the capacity estimation unit 115 may also be configured to estimate a range indicated by the maximum value and the minimum value of these estimated values as a range of the capacity index value of the target secondary battery 50 concerned.

Further, the embodiment in which the pieces of sample secondary battery information 701 acquired by the learning unit 117 are clustered or classified into any number of trend groups is described above, but the present invention is not limited to this embodiment.

In other words, for example, the pieces of sample secondary battery information 701 acquired by the learning unit 117 may be grouped into trend groups in advance. In this case, the process in which the learning unit 117 clusters or classifies the pieces of sample secondary battery information 701 into trend groups is omitted.

Description of Reference Numerals

10... secondary battery capacity estimation system, 50... target secondary battery, 70..sample secondary battery, 110... control unit, 111...target secondary battery information acquisition unit, 113 ...group determination unit, 115 ... capacity estimation unit, 117.. .learning unit, 130. ..storage unit, 131... classification model, 133...correlation information, 150.. .input unit, 170.. .output unit.

**Claims**

1.    A secondary battery capacity estimation system (10) that estimates a capacity of a secondary battery, comprising:

a target secondary battery information acquisition unit (111) that acquires target secondary battery information composed of information indicative of a usage history of a target secondary battery for which a capacity index value indicative of a degree of change in the capacity compared to an initial capacity of the secondary battery is to be estimated, and a resistance index value indicative of a degree of increase in internal resistance value compared to an initial internal resistance value of the target secondary battery;
a group determination unit (113) that inputs, to a classification model, the information indicative of the usage history of the target secondary battery and the resistance index value included in the target secondary battery information to determine to which of a plurality of trend groups, each indicative of a classification of a declining trend in the capacity index value by use, the target secondary battery is relevant;
a learning unit (117) that generates the classification model;
a storage unit (130) that stores correlation information indicative of a correlation between the resistance index value and the capacity index value of the secondary battery corresponding to each of the plurality of trend groups; and
a capacity estimation unit (115) that acquires the correlation information corresponding to the trend group determined by the group determination unit to which the target secondary battery is relevant to estimate the capacity index value of the target secondary battery based on the resistance index value included in the target secondary battery information and the acquired correlation information, wherein

the classification model is a trained model obtained by machine learning using, as training data, sample secondary battery information composed of pieces of information indicative of respective usage histories of a plurality of sample secondary batteries and resistance index values and capacity index values of the plurality of sample secondary batteries, and configured to output the trend group to which the target secondary battery is relevant when the target secondary battery information of the target secondary battery is input,

the information indicative of the usage history included in the sample secondary battery information is composed of pieces of information related to a plurality of items indicative of the usage histories of the sample secondary batteries, **characterised in that**

the classification model (131) is configured to classify the target secondary battery into any of the trend groups using weighting values for the items indicative of the usage histories of the sample secondary batteries, and the learning unit is configured to

perform machine learning using the sample secondary battery information as training data in order to calculate the weighting value for each of the items, and

perform the machine learning again using, as training data, information in which some of the items whose weighting values are a predetermined value or less are excluded in order to generate the classification model (131).

2. The secondary battery capacity estimation system according to claim 1, wherein each piece of the correlation information (133) corresponding to each of the trend groups is information obtained by classifying pieces of the sample secondary battery information into the trend groups to which the plurality of sample secondary batteries included in the sample secondary battery information are relevant, respectively, and analyzing a correlation between the resistance index value and the capacity index value related to each of sample secondary batteries relevant to each of the trend groups.

3. The secondary battery capacity estimation system according to claim 1 or 2, wherein the learning unit that generates the correlation information is configured to

extract, from the sample secondary battery information, pieces of information related to the sample secondary batteries whose capacity index values are a predetermined value or less,

classify the extracted pieces of information into the plurality of trend groups depending on a degree of decline in the capacity index value, and

analyze a correlation between the resistance index value and the capacity index value related to each of the sample secondary batteries relevant to each of the trend groups depending on the degree of decline in the capacity index value in order to generate the correlation information corresponding to each of the trend groups.

**Patentansprüche**

1. System zur Schätzung der Kapazität einer Sekundärbatterie (10), das die Kapazität einer Sekundärbatterie schätzt, umfassend:

eine Einheit zur Erfassung von Zielsekundärbatterie-Informationen (111), die Zielsekundärbatterie-Informationen erfasst, die aus Informationen, die eine Nutzungschronik einer Zielsekundärbatterie erkennen lassen, für die ein Kapazitätsindexwert, der einen Grad der Änderung der Kapazität im Vergleich zu einer Anfangskapazität der Sekundärbatterie erkennen lässt, geschätzt werden soll, sowie einem Widerstandsindexwert, der einen Grad der Zunahme des Innenwiderstandswerts im Vergleich zu einem anfänglichen Innenwiderstandswert der Zielsekundärbatterie erkennen lässt, zusammengesetzt sind;

eine Einheit zur Gruppenbestimmung (113), die die Informationen, die die Nutzungschronik der Zielsekundärbatterie erkennen lassen, sowie den in den Zielsekundärbatterie-Informationen enthaltenen Widerstandsindexwert in ein Klassifizierungsmodell eingibt, um zu bestimmen, für welche aus einer Vielzahl von Trendgruppen, von denen jede eine Klassifizierung eines Abwärtstrends des Kapazitätsindexwerts durch Nutzung erkennen lässt, die Zielsekundärbatterie relevant ist; eine Lerneinheit (117), die das Klassifikationsmodell generiert;

eine Speichereinheit (130), die eine Korrelation zwischen dem Widerstandsindexwert und dem Kapazitätsindexwert der Sekundärbatterie erkennen lassende Korrelationsinformationen speichert, die jeder der Vielzahl der Trendgruppen entsprechen; und

eine Einheit zur Schätzung der Kapazität (115), die die Korrelationsinformationen erfasst, die der von der Einheit zur Gruppenbestimmung bestimmten Trendgruppe, für die die Zielsekundärbatterie relevant ist, entsprechen, um den Kapazitätsindexwert der Zielsekundärbatterie basierend auf dem in den Zielsekundärbatterie-Informationen enthaltenen Widerstandsindexwert und den erfassten Korrelationsinformationen zu schätzen;

wobei

das Klassifizierungsmodell ein trainiertes Modell ist, das durch maschinelles Lernen erhalten wird, wobei als Trainingsdaten Informationen bezüglich Beispiel-Sekundärbatterien verwendet werden, die aus Teilen von Informationen zusammengesetzt sind, die die jeweiligen Nutzungschroniken einer Vielzahl von Beispiel-Sekundärbatterien sowie die Widerstandsindexwerte und Kapazitätsindexwerte der Vielzahl von Beispiel-Sekundärbatterien erkennen lassen, und das konfiguriert ist, die Trendgruppe, für die die Zielsekundärbatterie relevant ist, auszugeben, wenn die Zielsekundärbatterie-Informationen der Zielsekundärbatterie eingegeben werden,

die Informationen, die die in den Informationen bezüglich Beispiel-Sekundärbatterien enthaltene Nutzungschronik erkennen lassen, aus Teilen von Informationen in Bezug auf eine Vielzahl von Elementen, die die Nutzungschroniken der Beispiel-Sekundärbatterien erkennen lassen, zusammengesetzt sind

**dadurch gekennzeichnet, dass**

das Klassifikationsmodell (131) konfiguriert ist, die Zielsekundärbatterie unter Verwendung von Gewichtungswerten für die Elemente, die die Nutzungschroniken der Beispiel-Sekundärbatterien erkennen lassen, in eine der Trendgruppen zu klassifizieren,

und

die Lerneinheit konfiguriert ist,

maschinelles Lernen unter Verwendung der Informationen der Beispiel-Sekundärbatterien als Trainingsdaten durchzuführen, um den Gewichtungswert für jedes der Elemente zu berechnen, und

das maschinelle Lernen nochmals unter Verwendung von Informationen als Trainingsdaten, bei denen einige der Elemente, deren Gewichtungswerte einen vorbestimmten Wert oder weniger aufweisen, ausgeschlossen werden, durchzuführen, um das Klassifikationsmodell (131) zu generieren.

2. System zur Schätzung der Kapazität einer Sekundärbatterie gemäß Anspruch 1, wobei jeder Teil der Korrelationsinformationen (133), die jeder der Trendgruppen entsprechen, Information ist, die durch Klassifizieren von Teilen der Informationen bezüglich Beispiel-Sekundärbatterien in die Trendgruppen, für welche die Vielzahl von Beispiel-Sekundärbatterien, die in den Informationen bezüglich Beispiel-Sekundärbatterien enthalten sind, jeweils relevant sind, und durch Analysieren einer Korrelation zwischen dem Widerstandsindexwert und dem Kapazitätsindexwert in Bezug auf jede der für jede der Trendgruppen relevanten Beispiel-Sekundärbatterien erhalten wird.

3. System zur Schätzung der Kapazität einer Sekundärbatterie gemäß Anspruch 1 oder Anspruch 2, wobei die Lerneinheit, die die Korrelationsinformationen generiert, konfiguriert ist,

aus den Informationen bezüglich Beispiel-Sekundärbatterien Teile von Informationen unter Bezug auf die Beispiel-Sekundärbatterien, deren Kapazitätsindexwerte einen vorbestimmten Wert oder weniger aufweisen, zu extrahieren,

die extrahierten Teile von Informationen in Abhängigkeit von einem Grad der Abnahme des Kapazitätsindexwerts in die Vielzahl von Trendgruppen zu klassifizieren, und

eine Korrelation zwischen dem Widerstandsindexwert und dem Kapazitätsindexwert unter Bezug auf jede der Beispiel-Sekundärbatterien, die für jede der Trendgruppen in Abhängigkeit von dem Grad der Abnahme des Kapazitätsindexwerts relevant ist, zu analysieren, um die Korrelationsinformationen zu generieren, die jeder der Trendgruppen entsprechen.

## Revendications

1. Système d'estimation de la capacité d'une batterie secondaire (10) permettant d'estimer la capacité d'une batterie secondaire, comprenant :

une unité d'acquisition d'informations relatives à la batterie secondaire cible (111) qui acquiert des informations relatives à la batterie secondaire cible composées d'informations indiquant un historique d'utilisation d'une batterie secondaire cible pour laquelle une valeur d'indice de capacité, indiquant un degré de variation de la capacité comparé à une capacité initiale de la batterie secondaire, doit être estimée, et d'une valeur d'indice de résistance, indiquant un degré d'augmentation de résistance interne comparé à une valeur de résistance interne initiale de la batterie secondaire cible ;

une unité de détermination de groupe (113) qui entre, dans un modèle de classification, les informations indiquant l'historique d'utilisation de la batterie secondaire cible et la valeur d'indice de résistance incluse dans les informations de la batterie secondaire cible afin de déterminer auquel d'une pluralité de groupes de tendances, chacun indiquant une classification d'une tendance à la baisse de la valeur d'indice de capacité par utilisation, la batterie secondaire cible est pertinente ;
une unité d'apprentissage (117) qui génère le modèle de classification ;
une unité de stockage (130) qui stocke les informations de corrélation indiquant une corrélation entre la valeur d'indice de résistance et la valeur d'indice de capacité de la batterie secondaire correspondant à chacun de la pluralité de groupes de tendances ; et
une unité d'estimation de capacité (115) qui acquiert les informations de corrélation correspondant au groupe de tendances déterminé par l'unité de détermination de groupe auquel la batterie secondaire cible est pertinente afin d'estimer la valeur d'indice de capacité de la batterie secondaire cible sur la base de la valeur d'indice de résistance incluse dans les informations de batterie secondaire cible et les informations de corrélation acquises, dans lequel
le modèle de classification est un modèle entraîné, obtenu par apprentissage automatique, utilisant, comme données d'entraînement, des informations relatives à des batteries secondaires échantillonnées composées de parties individuelles d'informations indiquant les historiques d'utilisation respectifs d'une pluralité de batteries secondaires échantillonnées et les valeurs d'indice de résistance et les valeurs d'indice de capacité de la pluralité de batteries secondaires échantillonnées et configuré pour sortir le groupe de tendances auquel la batterie secondaire cible est pertinente lorsque les informations de la batterie secondaire cible de la batterie secondaire cible sont entrées,
les informations indiquant l'historique d'utilisation incluses dans les informations de batteries secondaires échantillonnées sont composées de parties individuelles d'informations relatives à une pluralité d'éléments indiquant les historiques d'utilisation des batteries secondaires échantillonnées, **caractérisé en ce que**
le modèle de classification (131) est configuré pour classer la batterie secondaire cible dans un quelconque des groupes de tendances en utilisant des valeurs de pondération pour les éléments indiquant les historiques d'utilisation des batteries secondaires échantillonnées, et
l'unité d'apprentissage est configurée pour

effectuer un apprentissage automatique en utilisant les informations de la batteries secondaires échantillonnées comme données d'apprentissage afin de calculer la valeur de pondération de chaque élément, et effectuer à nouveau l'apprentissage automatique en utilisant, comme données d'apprentissage, des informations dans lesquelles certains éléments dont les valeurs de pondération ont une valeur prédéterminée ou moins sont exclus afin de générer le modèle de classification (131).

2. Système d'estimation de la capacité d'une batterie secondaire selon la revendication 1, dans lequel chaque partie individuelle d'information de corrélation (133) correspondant à chacun des groupes de tendances est une information obtenue en classant des parties individuelles des informations de batteries secondaires échantillonnées dans les groupes de tendances auxquels la pluralité de batteries secondaires échantillonnées incluses dans les informations de batteries secondaires échantillonnées sont respectivement pertinents, et en analysant la corrélation entre la valeur d'indice de résistance et la valeur d'indice de capacité relative à chaque batteries secondaires échantillonnées pertinente pour chacun des groupes de tendances.

3. Système d'estimation de capacité de batterie secondaire selon la revendication 1 ou 2,
dans lequel l'unité d'apprentissage qui génère les informations de corrélation est configurée pour

extraire, à partir des informations de batteries secondaires échantillonnées, des parties individuelles d'informations relatives aux batteries secondaires échantillonnées dont les valeurs d'indice de capacité ont une valeur prédéterminée ou moins,
classer les parties individuelles d'informations extraites en la pluralité de groupes de tendances en fonction d'un degré de déclin de l'indice de capacité et
analyser une corrélation entre la valeur d'indice de résistance et la valeur d'indice de capacité relative à chaque batteries secondaires échantillonnées pertinente à chaque groupe de tendances, en fonction du degré de déclin de la valeur d'indice de capacité, afin de générer les informations de corrélation correspondant à chaque groupe de tendances.

## FIG.1

**ESTIMATION SYSTEM** (10)

**CONTROL UNIT** (110)
- TARGET SECONDARY BATTERY INFORMATION ACQUISITION UNIT (111)
- GROUP DETERMINATION UNIT (113)
- CAPACITY ESTIMATION UNIT (115)
- LEARNING UNIT (117)

**STORAGE UNIT** (130)
- CLASSIFICATION MODEL (131)
- CORRELATION INFORMATION (133)

**INPUT UNIT** (150)

**OUTPUT UNIT** (170)

## FIG.2

| TREND GROUP | CORRELATION INFORMATION |
|---|---|
| A | $f(x)=a_0x^n+a_1x^{n-1}+\cdots+a_{n-1}x^1+a_n$ |
| B | $g(x)=b_0x^n+b_1x^{n-1}+\cdots+b_{n-1}x^1+b_n$ |
| C | $h(x)=c_0x^n+c_1x^{n-1}+\cdots+c_{n-1}x^1+c_n$ |

## FIG.3

## FIG.4

```
                    ┌──────────┐
                    │  START   │
                    └──────────┘
                         │
                         ▼                              S11
        ◄─ IS INSTRUCTION TO EXECUTE LEARNING PROCESSING ACCEPTED? ─►  NO
                         │ YES                                          │
                         ▼                              S13            │
        ┌──────────────────────────────────────────────┐             │
        │             LEARNING PROCESSING              │             │
        └──────────────────────────────────────────────┘             │
                         │◄─────────────────────────────────────────────┘
                         ▼                              S31
        ◄─ IS INSTRUCTION TO EXECUTE ESTIMATION PROCESSING ACCEPTED? ─►  NO
                         │ YES                                          │
                         ▼                              S33            │
        ┌──────────────────────────────────────────────┐             │
        │             ESTIMATION PROCESSING            │             │
        └──────────────────────────────────────────────┘             │
                         │◄─────────────────────────────────────────────┘
                         ▼
                    ┌──────────┐
                    │   END    │
                    └──────────┘
```

18

## FIG.5

START

S110
ACQUIRE SAMPLE SECONDARY BATTERY INFORMATION

S130
MACHINE LEARNING OF SAMPLE SECONDARY BATTERY INFORMATION

S150
GENERATE CLASSIFICATION MODEL

S170
GENERATE CORRELATION INFORMATION CORRESPONDING TO EACH TREND GROUP

END

FIG.6

NEURAL NETWORK

GROUPS OF DECLINING
TRENDS IN CAPACITY
INDEX VALUE

- USAGE HISTORY

- RESISTANCE INDEX VALUE...
OF TARGET
SECONDARY BATTERY

A Group

B Group

C Group

EP 4 365 611 B1

## FIG.7

```
              ┌─────────────┐
              │    START    │
              └──────┬──────┘
                     │
                     ▼                                    S310
┌────────────────────────────────────────────────────────┐
│        ACQUIRE TARGET SECONDARY BATTERY INFORMATION      │
└──────────────────────┬──────────────────────────────────┘
                       │
                       ▼                                  S330
┌────────────────────────────────────────────────────────┐
│        DETERMINE TO WHICH OF TREND GROUPS TARGET         │
│            SECONDARY BATTERY IS RELEVANT                 │
└──────────────────────┬──────────────────────────────────┘
                       │
                       ▼                                  S350
┌────────────────────────────────────────────────────────┐
│   ACQUIRE CORRELATION INFORMATION CORRESPONDING TO TREND GROUP │
└──────────────────────┬──────────────────────────────────┘
                       │
                       ▼                                  S370
┌────────────────────────────────────────────────────────┐
│    ESTIMATE CAPACITY INDEX VALUE OF TARGET SECONDARY BATTERY │
└──────────────────────┬──────────────────────────────────┘
                       │
                       ▼                                  S390
┌────────────────────────────────────────────────────────┐
│               OUTPUT ESTIMATION RESULT                   │
└──────────────────────┬──────────────────────────────────┘
                       │
                       ▼
              ┌─────────────┐
              │     END     │
              └─────────────┘
```

## F|G.8

173

171

175

THE RESISTANCE INDEX VALUE OF THE SECONDARY BATTERY IS <u>57%</u>.

THE CAPACITY INDEX VALUE OF THE SECONDARY BATTERY IS <u>63%</u>.

**EP 4 365 611 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019187264 A
- JP 2018072346 A